# EUROPÄISCHE PATENTSCHRIFT

(11) **EP 1 671 355 B1**
(45) Veröffentlichungstag und Bekanntmachung des Hinweises auf die Patenterteilung: **15.10.2008**
(21) Anmeldenummer: 04787015.9
(22) Anmeldetag: 24.09.2004
(51) Int. Cl.: H01L 31/0352, H01L 31/042, H01L 31/05

(54) **Serienverschaltung von Solarzellen mit integrierten Halbleiterkörpern, Verfahren zur Herstellung und Photovoltaikmodul mit Serienverschaltung**
Series connection of solar cells with integrated semiconductor bodies, method of production and photovoltaic module with series connection
Connexion en série de cellules solaires comprenant des corps semiconducteurs intégrés, méthode de fabrication et module photovoltaïque avec connexion en série

(30) Priorität: 02.10.2003 EP 03022098
(43) Veröffentlichungstag der Anmeldung: 21.06.2006
(73) Patentinhaber: Scheuten Glasgroep, 5900 AA Venlo (NL)
(72) Erfinder: GEYER, Volker, 41372 Niederkrüchten (DE); KAAS, Patrick, NL-5632 MN Eindhoven (NL)
(74) Vertreter: Jostarndt, Hans-Dieter
(86) Internationale Anmeldenummer: PCT/EP2004/010781
(87) Internationale Veröffentlichungsnummer: WO 2005/034170

(56) Entgegenhaltungen:
- EP-A- 0 940 860
- DE-A- 10 052 914
- US-A- 3 736 476
- US-A- 4 173 494
- US-A- 4 407 320
- US-A- 4 582 588
- US-A- 5 578 503

## Beschreibung

Die Erfindung betrifft eine Serienverschaltung von Solarzellen mit integrierten Halbleiterkörpern.

Die Erfindung betrifft ferner ein Verfahren zur Herstellung einer Serienverschaltung von Solarzellen mit integrierten Halbleiterkörpern.

Die Erfindung betrifft ferner ein Photovoltaikmodul mit Serienverschaltung von Solarzellen.

In der Industrie besteht ein zunehmender Bedarf nach Verfahren zur Herstellung von Serienverschaltungen von Solargellen. Insbesondere auf dem speziellen Gebiet der Photovoltaik, bei dem zur Bildung eines p/n-Übergangs Halbleiterpartikel in ein Schichtsystem eingebracht werden, ist es sinnvoll, Bereiche aus Dünnschichten und Halbleiterpartikeln zu Zellen oder Arrays zusammenzufassen und diese Zellen in Serie zu verschalten, um höhere Spannungen abgreifen zu können. Das Problem der Serienverschältung von Solarzellen mit eingebrachten Halbleiterpartikeln ist jedoch noch nicht zufriedenstellend gelöst.

Die Deutsche Patentanmeldung DE 100 52 914 A1 beschreibt beispielsweise ein Halbleiterbauelementesystem, bei dem eine Halbleiterstruktur aus Schichten mit eingebrachten Halbleiterpartikeln an vorgegebenen Stellen komplett durchstoßen wird. In diese Löcher mit einer Größe von wenigen Hundert µm werden isolierte Leiterstifte eingebracht, die an der Vorderseite fest mit einer leitfähigen Schicht verbunden werden. Die Reihenverschaltung der Arrays wird über die Anbringung von Leiterbrücken vorgenommen, wonach die Arrays am Ende des Vorgangs voneinander elektrisch getrennt werden. Die Trennstellen werden mit isolierenden und gleichzeitig klebenden Materialien vergossen.

In einem anderen Ausführungsbeispiel, das ebenfalls in der Deutschen Offenlegungsschrift DE 100 52 914 A1 beschrieben wird, wird bei der Herstellung des Halbleiterbauelementesystems so verfahren, dass abwechselnd auf definierten Flächen unterschiedliche Halbleiterbauelementtypen (n- und p-Material) aufgebracht werden. So bilden sich auf einer Seite eines Systems abwechselnd Bereiche mit positiven oder negativen Elektroden aus, die durch eine integrierte Verschaltung in Reihe verbunden werden können. Dazu werden die Elektrodenschichten abwechselnd oben und unten unterbrochen. Die Aufbringung von unterschiedlichen Halbleiterbauelementtypen zur Erzeugung einer Fläche mit unterschiedlichen Elektroden stellt jedoch ein aufwändiges Verfahren dar.

Aus der US-Patentschrift US 4,407,320 ist ferner ein Verfahren zur Herstellung von Solarzellen bekannt, bei dem kugelförmige Halbleiterkörper in eine isolierende Schicht eingebracht werden. Die Kugeln weisen auf einer Seite einen Halbleiter vom Typ n auf, während sie auf der anderen Seite einen Halbleitertyp p aufweisen. Auf beiden Seiten der isolierenden Schicht wird jeweils eine leitende Schicht aufgebracht, um die Kugeln miteinander zu verbinden. Ferner werden leitende Trennlinien aus Kugeln, einer Paste oder beispielsweise einem Draht hergestellt. Um eine Serienverschaltung herzustellen, werden auf beiden Seiten der leitenden Trennlinie wechselseitig Schnitte in die leitenden Schichten eingebracht.

Es ist ferner bekannt, unabhängige sphärische Halbleiterbauelemente auszubilden, welche vollständige Halbleiter inklusive der erforderlichen Elektroden darstellen. Beispielsweise ist es aus der Europäischen Patentanmeldung EP 0 940 860 A1 bekannt, einen sphärischen Kern durch Maskierungen, Ätzschritte und das Aufbringen von verschiedenen Materialschichten zu einem sphärischen Halbleiterbauelement auszubilden. Derartige Halbleiterbauelemente können als Solarzellen eingesetzt werden, wenn der p/n-Übergang so gewählt ist, dass er einfallendes Licht in Energie umwandeln kann. Ist der p/n-Übergang so ausgebildet, dass er eine angelegte Spannung in Licht umwandeln kann, kann das Halbleiterbauelement als Licht emittierendes Element eingesetzt werden.

Ferner offenbart die US-Patentschrift US 5,578,503 ein Verfahren zum schnellen Herstellen von Chalkopyrit-Halbleiterschichten auf einem Substrat, bei dem einzelne Schichten der Elemente Kupfer, Indium oder Gallium und Schwefel oder Selen in elementarer Form oder als binäre zwischenelementare Verbindung auf ein Substrat aufgebracht werden. Das Substrat mit dem Schichtaufbau wird daraufhin schnell aufgeheizt und zwischen 10 Sekunden und einer Stunde auf einer Temperatur von ≥ 350°C gehalten.

Aufgabe der Erfindung ist es, ein Verfahren zur Herstellung von Serienverschaltungen von Solarzellen mit integrierten Halbleiterkörpern bereitzustellen, das mit wenigen und einfachen Verfahrensschritten durchführbar ist.

Ferner ist es Aufgabe der Erfindung, eine Serienverschaltung von Solarzellen mit integrierten Halbleiterkörpern bereitzustellen, die durch wenige und einfach durchzuführende Verfahrensschritte hergestellt ist.

Aufgabe der Erfindung ist es ferner, ein Photovoltaikmodul mit serienverschalteten Solarzellen bereitzustellen.

Erfindungsgemäß wird diese Aufgabe durch die Merkmale der Ansprüche 1, 15 und 36 gelöst. Vorteilhafte Weiterbildungen der Erfindung sind den Unteransprüchen zu entnehmen.

Bei dem erfindungsgemäßen Verfahren zur Herstellung einer Serienverschaltung von Solarzellen mit integrierten Halbleiterkörpern werden ein oder mehrere leitende Körper und kugel- oder kornförmige Halbleiterkörper nach einem Muster in eine isolierende Trägerschicht eingebracht, wobei die Körper wenigstens auf einer Seite der Trägerschicht aus der Oberfläche der Trägerschicht herausragen, und das Muster wenigstens eine durchgehende Trennlinie einer bestimmten Breite aus leitenden Körpern vorsieht. Die Bereiche neben einer Trennlinie oder zwischen mehreren Linien werden mit Halbleiterkörpern bestückt.

In einem besonders bevorzugten Ausführungsbeispiel der Erfindung sieht das Muster in der Trägerschicht vor, dass zwischen einer Trennlinie und einem Bereich, der mit Halbleiterkörpern bestückt ist, ein Abstand liegt, so dass sich neben einer Trennlinie ein dünner Streifen ergibt, in welchen Trennschnitte eingebracht werden können, ohne dass die leitenden Körper oder die Halbleiterkörper dabei berührt und ebenfalls durchtrennt werden. Es ist auch möglich, keinen Abstand vorzusehen, so dass die Trennschnitte so eingebracht werden, dass dadurch Teile der leitenden Körper und/oder der Halbleiterkörper abgetrennt werden.

Bei den in die Trägerschicht eingebrachten Körpern kann es sich beispielsweise um Körper aus Vollmaterial oder beschichtete Substratkerne handeln. Als leitende Körper können beispielsweise Partikel aus einem leitenden Material oder mit einem leitenden Material beschichtete Partikel zur Anwendung kommen. Bei dem leitenden Material handelt es sich in einem bevorzugten Ausführungsbeispiel der Erfindung um Kupfer. In der Erfindung werden als Halbleiterkörper mit I-III-VI-Verbindungshalbleitern beschichtete Substrate verwendet.

In einem weiteren Ausführungsbeispiel der Erfindung werden die leitenden Körper durch ein oder mehrere Bänder gebildet. Dies hat den Vorteil, dass eine durchgehende Trennlinie gebildet werden kann. Ferner hat es sich als zweckmäßig erwiesen, einen leitenden Körper in Form von Paste in die Trägerschicht einzubringen. Dies ist insbesondere von Vorteil, wenn es sich bei der Trägerschicht um eine Matrix mit Aussparungen für einzubringende Körper handelt. So kann die leitende Paste auf einer Seite der Matrix aufgebracht und durch die Aussparungen auf die andere Seite der Matrix gedrückt werden, so dass sich auf beiden Seiten eine leitende Trennlinie befindet, die durch die Trägerschicht hindurch kontaktiert sind.

Erfindungsgemäß werden Teile der Halbleiterkörper auf einer Seite der Trägerschicht abgetragen. Dies geschieht, um eine Fläche der Halbleiterkörper freizulegen, welche mit dem Rückkontakt der Solarzelle kontaktiert werden soll. Dabei handelt es sich vorzugsweise um eine Rückkontaktschicht, die auf dem Halbleiterkörper unterhalb einer Halbleiterschicht abgeschieden wurde, so dass ein Abtrag der Halbleiterschicht erforderlich ist. Ferner wird eine Rückkontaktschicht auf die Seite der Trägerschicht mit den abgetragenen Halbleiterkörpern und eine Vorderkontaktschicht auf die andere Seite der Trägerschicht aufgebracht. Die Vorderkontaktschicht und die Rückkontaktschicht bestehen aus einem leitfähigen Material.

Zur Herstellung einer Solarzelle werden je nach angestrebter Ausführungsform weitere Funktionsschichten aufgebracht, zu denen beispielsweise eine Bufferschicht aus CdS, intrinsisches Zinkoxid und/oder eine TCO-Schicht zählen können. In einem weiteren Ausführungsbeispiel der Erfindung umfassen die Halbleiterkörper neben einer Rückkontaktschicht und einer Halbleiterschicht weitere Funktionsschichten, zu denen ebenfalls eine Bufferschicht aus CdS, intrinisches Zinkoxid oder eine TCO-Schicht zählen können.

In einem weiteren Verfahrensschritt werden jeweils zwei Trennschnitte entlang einer Reihe aus leitenden Körpern eingebracht, wobei ein erster Trennschnitt in die Vorderkontaktschicht und ein zweiter Trennschnitt in die Rückkontaktschicht eingebracht wird. Die Trennschnitte liegen dabei auf unterschiedlichen Seiten der jeweiligen Trennlinie aus leitenden Körpern, und sie durchdringen die Rückkontaktschicht bis zu der Trägerschicht.

In einem besonders bevorzugten Ausführungsbeispiel der Erfindung ist die Reihe aus Leiterkörpern im Wesentlichen gerade und erstreckt sich zwischen zwei gegenüber liegenden Kanten der Trägerschicht. Das Muster aus Trennlinien aus Leiterkörpern und dazwischen liegenden Bereichen in Form von Solarzellen kann jedoch frei gewählt werden, so dass beispielsweise auch gebogene Trennlinien möglich sind.

Die Leiter- und Halbleiterkörper können beispielsweise aufgestreut und danach eingedrückt werden. In einem besonders bevorzugten Ausführungsbeispiel der Erfindung werden die kugel- oder kornförmigen Körper in eine Matrix einer Trägerschicht eingebracht, welche vorgefertigte Aussparungen für die Körper aufweist. Die Körper können beispielsweise durch einen Erwärmungs- und/oder Pressvorgang in die Trägerschicht eingebracht werden. Zur Aufbringung der Vorderkontakt- und Rückkontaktschicht eignen sich verschiedene PVD- und/oder CVD-Verfahren oder andere Verfahren, die der Art der jeweiligen Schicht angepasst sind. Wird beispielsweise ein leitfähiger Kleber verwendet, hat sich das Aufpinseln oder Aufschmieren des Klebers als zweckmäßig erwiesen.

Mit dem erfindungsgemäßen Verfahren lässt sich eine Serienverschaltung erzeugen, bei welcher der Strom durch einen Bereich aus Halbleiterkörpern der Vorderkontaktschicht in die Trennlinie aus leitenden Körpern fließt. Der Weiterfluss des Stromes aus den Leiterkörpern in den nächsten Bereich aus Halbleiterkörpern der Vorderkontaktschicht wird jedoch durch einen ersten Trennschnitt unterbunden, so dass der Strom über die Leiterkörper in den Rückkontakt fließt. Der Stromfluss durch den Rückkontakt wird dabei durch einen zweiten Trennschnitt im Rückkontakt unterbunden. So werden zwischen den Trennlinien aus leitenden Körpern Bereiche gebildet, die als Solarzelle wirken und die miteinander in Serie verschaltet sind.

Die erfindungsgemäße Serienverschaltung von Solarzellen mit integrierten Halbleiterkörpern weist dazu wenigstens eine isolierende Trägerschicht auf, in die leitende Körper und kugel- oder kornförmige Halbleiterkörper nach einem Muster eingebracht sind, wobei die Körper auf wenigstens einer Seite der Trägerschicht aus der Schicht herausragen. Das Muster sieht wenigstens eine Trennlinie einer bestimmten Breite aus leitenden Körpern vor, während die Bereiche neben einer Reihe oder zwischen mehreren Reihen mit Halbleiterkörpern bestückt sind.

Die Serienverschaltung weist ferner eine Vorderkontaktschicht und eine Rückkontaktschicht auf, wobei die Rückkontaktschicht auf der Seite der Trägerschicht liegt, auf welcher Teile der Halbleiterkörper abgetragen wurden. Jeweils zwei Trennschnitte sind entlang einer Trennlinie aus leitenden Körpern eingebracht, wobei ein erster Trennschnitt in die Vorderkontaktschicht und ein zweiter Trennschnitt in die Rückkontaktschicht eingebracht ist. Die Trennschnitte liegen auf unterschiedlichen Seiten der Reihe aus Leiterkörpern und durchdringen die Rückkontaktschicht bis zu der Trägerschicht.

Wird die Serienverschaltung mit dem erfindungsgemäßen Verfahren hergestellt, weist wenigstens einer der kugel- oder kornförmigen Halbleiterkörper auf der Seite der Trägerschicht, auf welcher die Rückkontaktschicht der Solarzelle angeordnet ist, eine Fläche auf, über die ein direkter Kontakt zwischen der Rückkontaktschicht der Solarzelle und einer Rückkontaktschicht des Halbleiterkörpers erfolgt. Da es sich bei den Halbleiterkörpern um mit einem Rückkontakt und einem Halbleiter beschichtete Substrate handelt, werden die Halbleiterkörper soweit entschichtet, dass eine Fläche aus Rückkontakt entstanden ist, die mit der Rückkontaktschicht der Solarzelle kontaktiert werden kann. Weisen die Halbleiterkörper neben einer Rückkontaktschicht und einer Halbleiterschicht weiter Funktionsschichten auf, wurden diese ebenfalls so abgetragen, dass eine Fläche aus Rückkontakt frei liegt.

Der wesentliche Vorteil der erfindungsgemäßen Serienverschaltung von Solarzellen und dem zugehörigen Verfahren zur Herstellung liegt in der einfachen Ausführung der Verschaltung der Solarzellenbereiche, welche nur wenige Bearbeitungsschritte erfordert. Die erforderlichen leitenden Körper können in verschiedenen Formen und auf unterschiedliche Weisen eingebracht werden und die Einbringung der Trennschnitte stellt ebenfalls einen einfachen Verfahrensschritt dar.

Werden kugel- oder kornförmige Körper verwendet, können diese mit dem gleichen Verfahren wie die Halbleiterkörper eingebracht werden, so dass dafür keine zusätzlichen Verfahren oder Vorrichtungen entwickelt und angewendet werden müssen. Wird beispielsweise eine Paste als leitender Körper verwendet, die auf eine Trägermatrix mit Aussparungen aufgebracht wird, lassen sich auf einfache Weise zwei über die Trägerschicht verbundene Trennlinien erzeugen. Ferner ist der zusätzliche Materialaufwand gering, da lediglich leitende Körper eingebracht werden müssen. Die eingebrachten Trennschnitte stellen dabei keine Beeinträchtigung der gesamten Anordnung dar, da die Schwächung der Gesamtstruktur sehr gering ist.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Abbildungen.

Von den Abbildungen zeigt:
- Fig. 1: in den Abbildungen (a)-(c) die Einbettung von kugelförmigen Halbleiter- und Leiterpartikeln in eine Trägerschicht;
- Fig. 2: in den Abbildungen (a)-(c) den Aufbau von Vorder- und Rückkontaktschichten; und
- Fig. 3: in den Abbildungen (a)-(b) die erfindungsgemäße Serienverschaltung von Solarzellen mit integrierten Halbleiterpartikeln;
- Fig. 4: ein besonders bevorzugtes Ausführungsbeispiel einer schindelartigen Verschaltung mehrerer Serienverschaltungen.

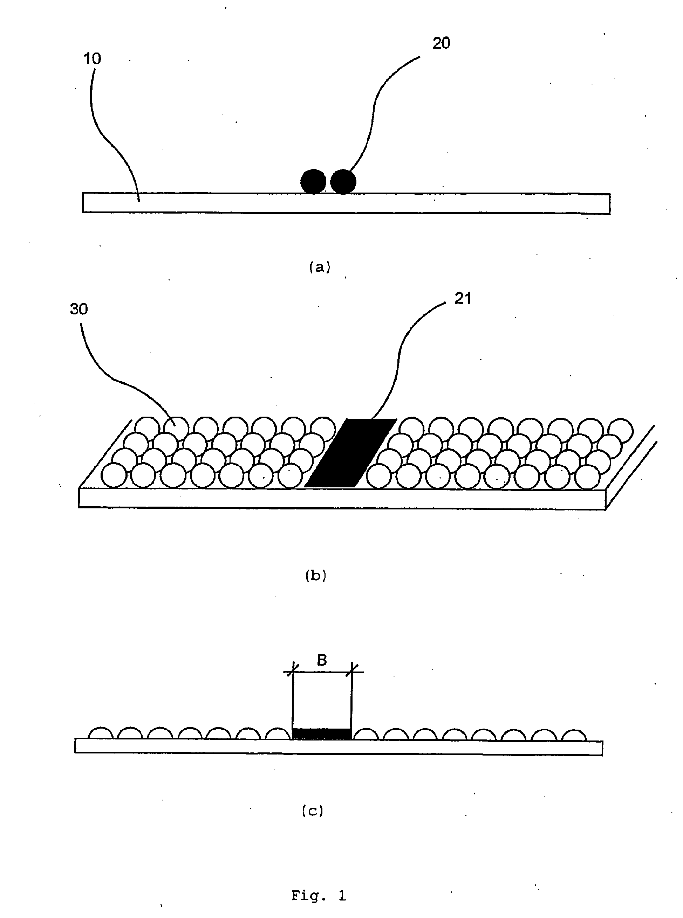

In den Abbildungen (a)-(c) der Fig. 1 ist die Einbringung von kugel- oder kornförmigen leitenden Körpern 20 und Halbleiterkörpern 30 in eine isolierende Trägerschicht 10 dargestellt. Dabei hat es sich als zweckmäßig erwiesen, als Trägerschicht eine flexible Folie zu verwenden. Die Trägerschicht besteht vorzugsweise aus einem thermoplastischen Material, in welche die leitenden Körper eingedrückt werden können. Besonders zweckmäßig hat sich Polymer erwiesen, bei dem es sich beispielsweise um ein Polymer aus der Gruppe der Epoxide, Polycarbonate, Polyester, Polyurethane, Polyacryle und/oder Polyimide handeln kann.

Bei den eingebetteten Körpern handelt es sich vorzugsweise um kugel- oder kornförmige Partikel mit leitenden oder halbleitenden Eigenschaften. Neben der reinen Kugelform können die Körper auch unregelmäßige Formen wie die von Körnern jeglicher Kontur annehmen. Dazu zählen beispielsweise auch Würfel, Quader oder Pyramiden. Als Leiterkörper 20 können daher Kugeln oder Körner aus leitenden Materialien wie Kupfer eingesetzt werden. In einem weiteren besonders bevorzugten Ausführungsbeispiel der Erfindung werden die leitenden Körper in Form von Bändern oder einer Paste eingebracht, welche die Form einer Trennlinie bilden.

Die Halbleiterkörper bestehen vollständig oder zum Teil aus geeigneten Halbleitermaterialien der Photovoltaik. In der Erfindung sind die Halbleitermaterialien aus der Klasse der I-III-VI-Verbindungshalbleiter, zu denen beispielsweise Kupferindiumdiselenid, Kupferindiumdisulfid, Kupferindiumgalliumdiselenid oder Kupferindiumgalliumdiseleniddisulfid zählen.

Dabei handelt es sich um mit Halbleitermaterialien beschichtete Substratkerne.

Die leitenden Körper und die Halbleiterkörper werden so in die Trägerschicht 10 eingebracht, dass sie wenigstens auf einer Seite der Trägerschicht aus der Oberfläche der Schicht herausragen. Die Körper können dazu beispielsweise durch Streuen, Stäuben und/oder Drucken aufgebracht und danach eingedrückt werden. Zum Eindrücken der Körper in die Trägerschicht kann diese beispielsweise erwärmt werden. Die Körper können beispielsweise mit einem Hilfsmittel zu einem gewünschten Muster angeordnet und so auf oder in der Trägerschicht platziert werden.

In einem besonders bevorzugten Ausführungsbeispiel der Erfindung werden die Körper in eine vorgefertigte Matrix einer Trägerschicht eingebracht, in der sich Aussparungen befinden, in welche die jeweiligen Körper eingefügt werden. Zur Befestigung der Körper an der Trägerschicht kann ein Erwärmungs- und/oder Pressvorgang durchgeführt werden. Wird beispielsweise eine Paste als leitfähiger Körper verwendet, kann die Paste auf'gewünschte Bereiche der Matrix aufgebracht und in die dortigen Aussparungen gedrückt werden. Auf der Rückseite der Trägerschicht kann die Paste verstrichen werden, so dass sich auf beiden Seiten der isolierenden Trägerschicht eine Trennlinie bildet, welche durch die Aussparungen miteinander verbunden sind.

Die leitenden Körper werden nach einem Muster in die Trägerschicht eingebracht, das wenigstens eine im Wesentlichen gerade Trennlinie einer bestimmten Breite aus leitenden Körpern 20 vorsieht. Dass die Reihe im Wesentlichen gerade ist, bedeutet in diesem Zusammenhang, dass auch geringfügige Abweichungen von einer Geraden umfasst sind. Soll für bestimmte Anwendungen eine geometrisch andere Abgrenzung zwischen einzelnen Solarzellen erfolgen, kann ein anderer Verlauf der Reihen aus Leiterkörpern wie beispielsweise bogenförmige Trennlinien gewählt werden.

Vorzugsweise erstreckt sich die Trennlinie aus Leiterkörpern zwischen zwei gegenüber liegenden Kanten der Trägerschicht 10. Die Breite der Reihen aus Leiterkörpern liegt vorzugsweise in der Größenordnung von 10µm-3mm und ist je nach Abmessung der verwendeten Leiterkörper beispielsweise durch einen oder mehrere Leiterkörper gegeben. In einem besonders bevorzugten Ausführungsbeispiel der Erfindung liegt die Breite der Trennlinien zwischen 10µm-30µm. Werden als leitende Körper kugel- oder kornförmige Partikel verwendet, richtet sich die Breite der Trennlinien nach dem Durchmesser der verwendeten Partikel. Die Breite der Trennlinien kann somit auch in der Größenordnung von einem oder mehreren Durchmessern einer leitenden Kugel, insbesondere zwischen 10-500µm, liegen.

Je nach gewünschter Breite einer zu verschaltenden Solarzelle wird eine Trägerschicht durch mehrere Reihen aus Leiterkörpern in entsprechende Bereiche aufgeteilt. Die Bereiche neben einer Trennlinie oder zwischen mehreren Trennlinien werden mit Halbleiterkörpern bestückt. Die Breite einer so begrenzten Solarzelle liegt vorzugsweise in der Größenordnung von 1mm-3cm. In einem besonders bevorzugten Ausführungsbeispiel der Erfindung liegt die Breite einer Solarzelle zwischen 3-5mm. Die Breite einer Trägerschicht mit einer so gebildeten Serienverschaltung liegt vorzugsweise in der Größenordnung von 5-30cm, wobei es sich als besonders vorteilhaft erwiesen hat, bandförmige Module aus mehreren serienverschalteten Solarzellen auszubilden, die vorzugsweise eine Breite von etwa 10cm aufweisen.

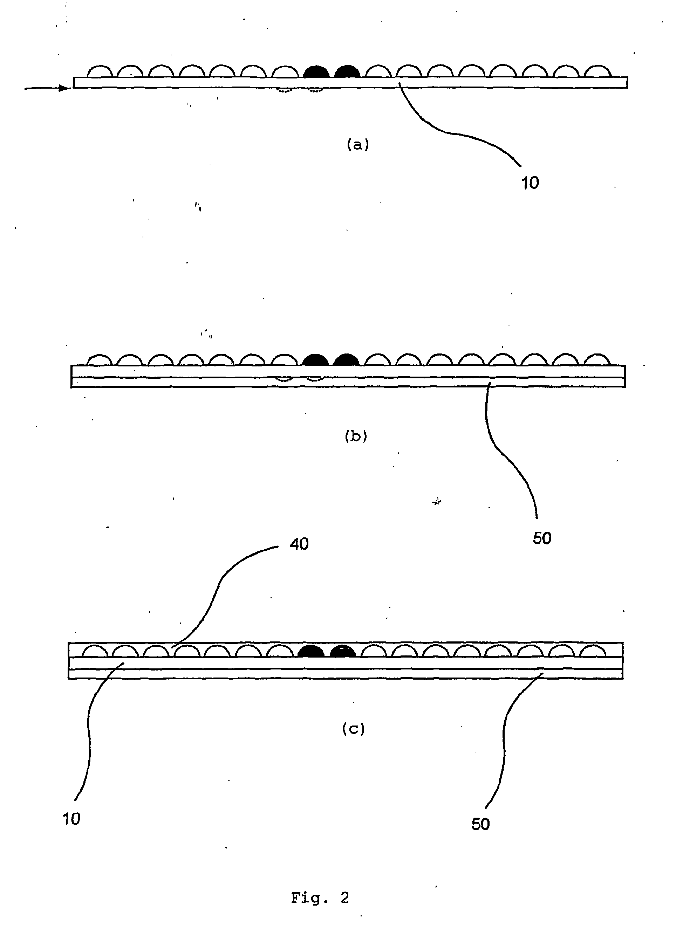

Den Abbildungen (a)-(c) der Fig. 2 ist die Bildung des Schichtaufbaus zur Herstellung einer Solarzelle mit integrierten Halbleiterkörpern zu entnehmen. In einem besonders bevorzugten Ausführungsbeispiel der Erfindung wird als erster Schritt Material der Trägerschicht 10 auf einer Seite abgetragen. Diese Seite wird bis zu einer Schichtdicke abgetragen, bei der Teile der eingebrachten Körper mit abgetragen werden. Die mit abgetragenen Bereiche der Körper sind in Abbildung (a) durch die verbleibenden gestrichelten Umrisse zweier Leiter- und Halbleiterkörper dargestellt. Der Abtrag der Trägerschicht kann jedoch auch zu anderen Zeitpunkten erfolgen, die vor der Aufbringung eines späteren Rückkontakts 50 auf dieser Seite liegen.

In einem anderen Ausführungsbeispiel der Erfindung ragen die Halbleiterkörper nach der Einbringung auf einer Seite der Trägerschicht so weit heraus, dass Teile davon abgetragen werden können, ohne dass ein gleichzeitiger Abtrag der Trägerschicht erforderlich ist. Der Abtrag der leitenden Körper, der Halbleiterkörper und/oder der Trägerschicht kann beispielsweise durch mechanische Verfahren wie Schleifen, Polieren, chemische oder nasschemische Verfahren (Prozesse) wie Ätzen, Photolitographie oder thermischen Energieeintrag z.B. über das Lasern und oder Bestrahlen mit Licht geeigneter Wellenlänge/Wellenlängenbereichs oder aber andere thermische Verfahren erfolgen.

Das Maß des Abtrags hängt vorrangig von den verwendeten Halbleiterkörpern ab. Werden beispielsweise kugel- oder kornförmige Substratkerne eingesetzt, die wenigstens mit einer Rückkontaktschicht und einer Halbleiterschicht beschichtet sind, erfolgt ein Abtrag bis zur Freilegung der Rückkontaktschicht des Partikels, um den Kontakt zum Rückkontakt der Solarzelle herzustellen. In der Erfindung handelt es sich bei den Halbleiterkörpern um Substratkerne, die mit einem Rückkontakt aus Molybdän und einem Halbleiter beschichtet sind. Ein Abtrag der Trägerschicht wird bis zu einer Schichtdicke durchgeführt, in welcher die Molybdänschicht der Körper freigelegt ist.

Dabei ist der Abtrag ferner davon abhängig, ob sich alle Halbleiterkörper gleich tief in der Trägerschicht befinden. Sind die Halbleiterkörper unterschiedlich tief eingebettet oder variiert die Größe der Körper, besteht die Möglichkeit, dass nicht alle Halbleiterkörper exakt bis zu ihrer Rückkontaktschicht entschichtet werden.

In einem weiteren Verfahrensschritt wird eine Rückkontaktschicht 50 auf die Seite der Trägerschicht 10 aufgebracht, auf der wenigstens Teile der Halbleiterkörper abgetragen wurden. Als Material für diesen Rückkontakt werden leitende Stoffe wie Metalle eingesetzt. Es können auch TCOs (Transparent Conductive Oxide) oder Stoffe aus diversen Polymerklassen verwendet werden. Besonders geeignet sind beispielsweise Epoxidharze, Polyurethane, und/oder Polyimide, die mit geeigneten leitfähigen Partikeln wie Kohlenstoff, Indium, Nickel, Molybdän, Eisen, Nickelchrom, Silber, Aluminium und/oder entsprechenden Legierungen bzw. Oxiden versehen sind. Eine weitere Möglichkeit stellen intrinsische leitfähige Polymere dar. Dazu zählen beispielsweise Polymere aus der Gruppe der PANis. Der Rückkontakt kann mit PVD-Verfahren wie dem Sputtern und Aufdampfen oder CVD-Verfahren wie PE-CVD oder MO-CVD oder aber auch auf eine andere, dem Rückkontaktmaterial angepasste Art und Weise hergestellt werden.

Im einem weiteren Verfahrensschritt wird eine leitende Vorderkontaktschicht 40 auf der Seite der Trägerschicht abgeschieden, auf der keine Bearbeitung der Körper erfolgte. Auch dies kann mit PVD- , CVD-Verfahren oder anderen, an das Vorderkontaktmaterial angepasste, Verfahren erfolgen. Als Material des Vorderkontakts können beispielsweise diverse TCOs (Transparent Conductive Oxides)(z.B. Aluminium dotiertes Zinkoxid (ZnO:Al) (auch AZO genannt), Indiumzinnoxid (ITO) oder Fluor dotiertes Zinnoxid (SnO₂:F) eingesetzt werden. Es hat sich als zweckmäßig erwiesen, einen transparenten Vorderkontakt einzusetzen, dessen Transmission vorzugsweise dem jeweiligen Halbleiter angepasst ist.

Vor der Abscheidung eines Vorder- und/oder Rückkontaktes können weitere Funktionsschichten abgeschieden werden. Dazu zählen beispielsweise eine Bufferschicht aus CdS, intrinsisches Zinkoxid oder eine weitere TCO-Schicht. In einem besonders bevorzugten Ausführungsbeispiel der Erfindung werden diese Funktionsschichten bereits auf den verwendeten Halbleiterkörpern abgeschieden, so dass eine erneute Abscheidung zur Herstellung einer Solarzelle gegebenenfalls nicht mehr erforderlich ist.

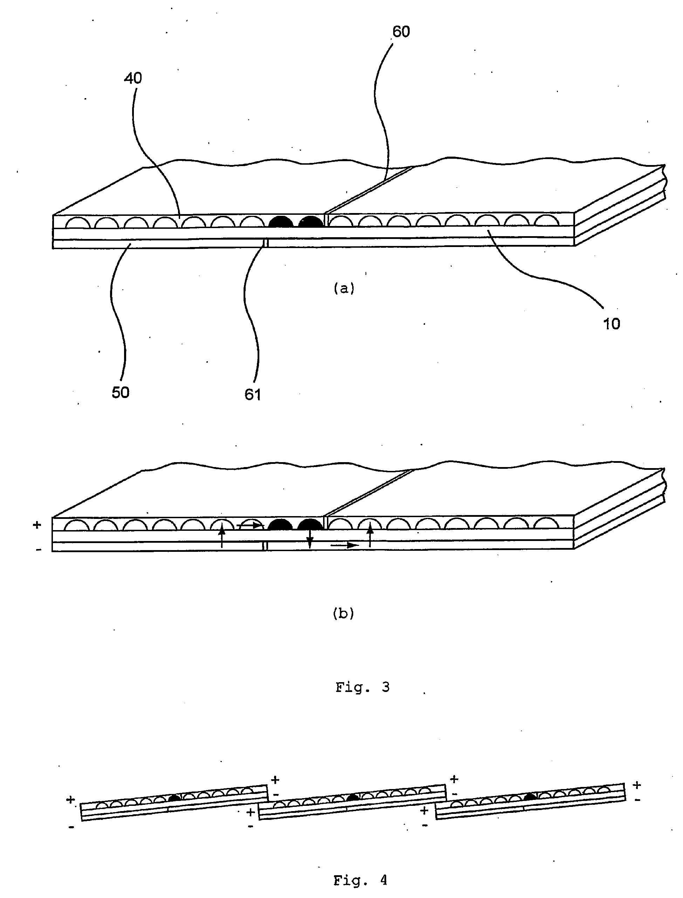

Als weiterer wesentlicher Verfahrensschritt werden jeweils zwei Trennschnitte 60 und 61 entlang einer Reihe aus leitenden Körpern eingebracht, wie es in der Abbildung (a) der Fig. 3 dargestellt ist. Ein Trennschnitt 60 wird dabei in die Vorderkontaktschicht 40 und ein Trennschnitt 61 in die Rückkontaktschicht eingebracht, wobei die Trennschnitte auf unterschiedlichen Seiten der Reihe aus leitenden Körpern 20 liegen. Die Trennschnitte können durch Verfahren wie Schneiden, Ritzen, thermischen Energieeintrag wie z.B. beim Laserschnitt oder photolithographische Prozesse eingebracht werden.

In einem besonders bevorzugten Ausführungsbeispiel der Erfindung werden die erzeugten Trennschnitte mit einem isolierenden Material aufgefüllt, um eine möglichst ebene Oberfläche der Solarzellenverschaltung zu erreichen. Dieser Schritt ist jedoch optional, da die erforderliche Tiefe der Trennschnitte 60;61 aufgrund der dünnen Vorder- und Rückkontaktschichten im µm-Bereich sehr gering ist.

Ist das Verfahren abgeschlossen, so dass alle Abscheidungs- und Trennschritte durchgeführt sind, stellen die resultierenden Schichten mit den integrierten Halbleiterkörpern eine Serienverschaltung von Solarzellen dar, die in einem Photovoltaikmodul eingesetzt werden können. Ein Photovoltaikmodul kann je nach Ausführungsform eine oder mehrere Serienverschaltungen umfassen. Der resultierende Stromverlauf ist in Fig. 3 in der Abbildung (b) durch einen Pfeilverlauf dargestellt. In dem dargestellten Ausführungsbeispiel liegt der negative Vorderkontakt oben, während der positive Rückkontakt unten liegt. Der Strom fließt über die Halbleiterkörper 30 im Vorderkontakt in die leitenden Körper 20 und von da in den Rückkontakt 50, da der weitere Stromfluss durch den ersten Trennschnitt 60 unterbunden ist. Der Stromfluss durch den Rückkontakt 50 wird durch den zweiten Trennschnitt 61 unterbunden.

In einem besonders bevorzugten Ausführungsbeispiel der Erfindung wird ein derartige Serienverschaltung mit wenigstens einer weiteren entsprechenden Serienverschaltung zu einem größeren Modul verbunden. Dies geschieht beispielsweise dadurch, dass die einzelnen Serienverschaltungen bandförmig mit einer Breite in der Größenordnung von 5-30cm ausgebildet sind und die so gebildeten Submodule an den Rändern schindelartig übereinander gelegt werden. Dies ist in Fig. 4 dargestellt. So kommt ein Rückkontakt auf einem Vorderkontakt zu liegen und die einzelnen Module sind wiederum in Serie verschaltet. Die Kontaktierung zwischen jeweiliger Vorder- und Rückkontaktschicht kann beispielsweise über einen leitfähigen Kleber wie Silber-Epoxid erfolgen.

### Bezugszeichenliste:

- 10: Trägerschicht, Folie
- 20: leitende Körper, Leiterkörper
- 21: Trennlinie
- 30: Halbleiterkörper, kugel-/kornförmig
- 40: Vorderkontaktschicht
- 50: Ruckkontaktschicht
- 60, 61: Trennschnitte

## Patentansprüche

1. Verfahren zur Herstellung einer Serienverschaltung von Solarzellen mit integrierten Halbleiterkörpern,
**gekennzeichnet**
**durch** folgende Merkmale:
- Einbringen von einem oder mehreren leitenden Körpern (20) in eine isolierende Trägerschicht (10) nach einem Muster wobei die leitenden Körper (20) wenigstens auf einer Seite der Trägerschicht aus der Oberfläche der Trägerschicht herausragen, und das Muster wenigstens eine Trennlinie (21) einer bestimmten Breite vorsieht, die aus einem oder mehreren leitenden Körpern (20) gebildet wird;
- Einbringen von mehreren kugel- oder kornförmigen Halbleiterkörpern (30) in die isolierende Trägerschicht (10) nach einem Muster, wobei die Halbleiterkörper (30) aus Substratkernen bestehen, die wenigstens mit einer leitenden Rückkontaktschicht aus Molybdän und einer darüber angeordneten Halbleiterschicht aus einem I-III-VI-Verbindungshalbleiter beschichtet sind, und die Halbleiterkörper (30) wenigstens auf einer Seite der Trägerschicht aus der Oberfläche der Trägerschicht herausragen, und das Muster vorsieht, dass die Bereiche neben einer oder zwischen mehreren Trennlinien (21) aus leitenden Körpern (20) mit Halbleiterkörpern (30) bestückt werden;
- Abtragen von Teilen der Halbleiterkörper (30) auf einer Seite der Trägerschicht (10) bis die Rückkontaktschicht der Halbleiterkörper (30) frei gelegt ist;
- Aufbringen einer leitenden Rückkontaktschicht (50) auf die Seite der Trägerschicht (10), auf welcher Teile der Halbleiterkörper (30) abgetragen wurden;
- Aufbringen einer leitenden Vorderkontaktschicht (40) auf die Seite der Trägerschicht (10), auf der keine Halbleiterkörper abgetragen wurden, wobei vor der Abscheidung der Vorderkontaktschicht (40) und/oder der Rückkontaktschicht (50) eine Bufferschicht aus CdS und/oder eine Schicht aus intrinsischem Zinkoxid abgeschieden werden oder eine Bufferschicht aus CdS und/oder eine Schicht aus intrinsischem Zinkoxid bereits auf den verwendeten korn- oder kugelförmigen Halbleiterkörpern (30) abgeschieden, wurden, und wobei die Bereiche neben einer oder zwischen zwei Trennlinien (21) jeweils eine Solarzelle bilden;
- Einbringen von jeweils zwei Trennschnitten (60;61) entlang einer Trennlinie (21) aus leitenden Körpern (20), wobei ein erster Trennschnitt (60) in die Vorderkontaktschicht (40) und ein zweiter Trennschnitt (61) in die Rückkontaktschicht eingebracht wird, die Trennschnitte auf unterschiedlichen Seiten der jeweiligen Trennlinie (21) liegen, und die Trennschnitte (60;61) die Rückkontaktschicht (50) bis zu der Trägerschicht (10) durchdringen.

2. Verfahren nach Anspruch 1,
**dadurch gekennzeichnet,**
**dass** die kugel- oder kornförmigen Halbleiterkörper (30) eine Schicht aus einem TCO (Transparent Conductive Oxide) aufweisen.

3. Verfahren nach einem oder beiden der vorangegangen Ansprüche 1 und 2,
**dadurch gekennzeichnet,**
**dass** neben dem Abtragen von Teilen der Halbleiterkörper (30) Teile der leitenden Körper (20) abgetragen werden.

4. Verfahren nach einem oder mehreren der vorangegangen Ansprüche,
**dadurch gekennzeichnet,**
**dass** neben dem Abtragen von Teilen der Halbleiterkörper (30) ein Teil der Trägerschicht (10) abgetragen wird.

5. Verfahren nach einem oder mehreren der vorangegangen Ansprüche,
**dadurch gekennzeichnet,**
**dass** die leitenden Körper (20) und/oder die Halbleiterkörper (30) durch Streuen, Stäuben und/oder Drucken auf die Trägerschicht (10) aufgebracht und danach in die Trägerschicht eingebracht werden.

6. Verfahren nach einem oder mehreren der vorangegangen Ansprüche,
**dadurch gekennzeichnet,**
**dass** mehrere leitende Körper (20) in Form von kugel- oder kornförmigen Partikeln, in Form von Bändern oder in Form einer Paste in die Trägerschicht (10) eingebracht werden.

7. Verfahren nach einem oder mehreren der vorangegangenen Ansprüche,
**dadurch gekennzeichnet,**
**dass** die Trägerschicht (10) eine Matrix mit Aussparungen ist, in welche die Körper (20;30) eingebracht werden.

8. Verfahren nach einem oder mehreren der vorangegangenen Ansprüche,
**dadurch gekennzeichnet,**
**dass** die Körper (20;30) durch einen Erwärmungs- und/oder Pressvorgang in die Trägerschicht (10) eingebracht werden.

9. Verfahren nach einem oder mehreren der vorangegangenen Ansprüche,
**dadurch gekennzeichnet,**
**dass** sich eine Trennlinie (21) aus leitenden Körpern (20) zwischen zwei gegenüber liegenden Kanten der Trägerschicht (10) erstreckt.

10. Verfahren nach einem oder mehreren der vorangegangenen Ansprüche,
**dadurch gekennzeichnet,**
**dass** das Abtragen der Teilen der Körper (20;30) und/oder der Trägerschicht (10) durch Schleifen, Polieren, Ätzen, thermischen Energieeintrag und/oder photolithographische Prozesse erfolgt.

11. Verfahren nach einem oder mehreren der vorangegangenen Ansprüche,
**dadurch gekennzeichnet,**
**dass** die Rückkontaktschicht (50) und die Vorderkontaktschicht (40) durch PVD-Verfahren, CVD-Verfahren oder andere auf die Art der jeweiligen Schicht abgestimmte Verfahren abgeschieden werden.

12. Verfahren nach einem oder mehreren der vorangegangenen Ansprüche,
**dadurch gekennzeichnet,**
**dass** die Trennschnitte (60;61) durch Verfahren wie Schneiden, Ritzen, Ätzen, thermischen Energieeintrag oder photolithographische Prozesse eingebracht werden.

13. Verfahren nach einem oder mehreren der vorangegangenen Ansprüche,
**dadurch gekennzeichnet,**
**dass** die Breite einer Trennlinie (21) in der Größenordnung von 10µm-3mm, insbesondere zwischen 10µm-500µm, liegt.

14. Verfahren nach einem oder mehreren der vorangegangenen Ansprüche,
**dadurch gekennzeichnet,**
**dass** der Abstand zwischen zwei Trennlinien (21) in der Größenordnung von 1mm-3cm, insbesondere zwischen 3mm-5mm, liegt.

15. Serienverschaltung von Solarzellen mit integrierten Halbleiterkörpern,
**dadurch gekennzeichnet,**
**dass** die Serienverschaltung wenigstens folgende Merkmale aufweist:
- eine isolierende Trägerschicht (10), in welche ein oder mehrere leitende Körper (20) nach einem Muster eingebracht sind, wobei die leitenden Körper (20) wenigstens auf einer Seite der Trägerschicht aus der Oberfläche der Trägerschicht herausragen, und das Muster wenigstens eine Trennlinie (21) einer bestimmten Breite vorsieht, die aus einem oder mehreren leitenden Körpern (20) gebildet sind;
- mehrere kugel- oder kornförmige Halbleiterkörper (30) in der isolierenden Trägerschicht (10), wobei die Halbleiterkörper (30) aus einem Substratkern bestehen, der wenigstens mit einer leitenden Rückkontaktschicht aus Molybdän und einer Halbleiterschicht aus einem I-III-VI-Verbindungshalbleiter beschichtet ist und die Halbleiterkörper (30) wenigstens auf einer Seite der Trägerschicht aus der Oberfläche der Trägerschicht herausragen und ein Muster bilden, in dem die Bereiche neben einer oder zwischen mehreren Trennlinien (21) mit Halbleiterkörpern (30) bestückt sind;
- eine leitende Vorderkontaktschicht (40) auf einer Seite der Trägerschicht (10), auf der die Körper (20;30) aus der Schicht herausragen;
- eine leitende Rückkontaktschicht (50) auf der Seite der Trägerschicht, die der Vorderkontaktschicht (40) gegenüber liegt;
- eine Bufferschicht aus CdS und/oder eine Schicht aus intrinsischem Zinkoxid auf den verwendeten korn- oder kugelförmigen Halbleiterkörpern (30);
- Bereiche neben einer oder zwischen zwei Trennlinien (21) bilden jeweils eine Solarzelle;
- jeweils zwei Trennschnitte (60;61) entlang einer Reihe aus Leiterkörpern (20), wobei ein erster Trennschnitt (60) in die Vorderkontaktschicht (40) und ein zweiter Trennschnitt (61) in die Rückkontaktschicht eingebracht ist, die Trennschnitte auf unterschiedlichen Seiten der jeweiligen Reihe aus Leiterkörpern (20) liegen, und die Trennschnitte (60;61) die Rückkontaktschicht (50) bis zu der Trägerschicht (10) durchdringen; und
- wenigstens einer der Halbleiterkörper (30) auf der Seite der Trägerschicht (10), auf welcher die Rückkontaktschicht (50) der Solarzelle angeordnet ist, eine Fläche aufweist, über die ein direkter Kontakt zwischen der Rückkontaktschicht (50) der Solarzelle und der Rückkontaktschicht des Halbleiterkörpers (30) besteht.

16. Serienverschaltung nach Anspruch 15,
**dadurch gekennzeichnet,**
**dass** die Trägerschicht (10) aus einem thermoplastischen Material besteht.

17. Serienverschaltung nach einem oder beiden der Ansprüche 15 und 16,
**dadurch gekennzeichnet,**
**dass** die Trägerschicht (10) aus einem Polymer aus der Gruppe der Epoxide, Polyurethane, Polyacryle, Polycarbonate, Polyester und/oder Polyimide besteht.

18. Serienverschaltung nach einem oder mehreren der Ansprüche 15 bis 17,
**dadurch gekennzeichnet,**
**dass** ein leitender Körper (20) durch eine Paste oder ein Band gebildet wird.

19. Serienverschaltung nach einem oder mehreren der Ansprüche 15 bis 18,
**dadurch gekennzeichnet,**
**dass** ein leitender Körper (20) durch einen kugel- oder kornförmigen Partikel gebildet wird.

20. Serienverschaltung nach Anspruch 19,
**dadurch gekennzeichnet,**
**dass** ein leitender Körper (20) in Vollmaterial aus einem leitenden Material besteht, oder ein leitender Körper (20) aus einem Substratkern besteht, der mit einem leitenden Material beschichtet ist.

21. Serienverschaltung nach Anspruch 20,
**dadurch gekennzeichnet,**
**dass** ein leitender Körper (20) in Vollmaterial aus Kupfer oder einem Substratkern besteht, der mit Kupfer beschichtet ist.

22. Serienverschaltung nach einem oder mehreren der Ansprüche 15 bis 21,
**dadurch gekennzeichnet,**
**dass** die Halbleiterkörper, (30) eine Schicht aus einem TCO (Transparent Conductive Oxide) aufweisen.

23. Serienverschaltung nach einem oder mehreren der Ansprüche 15 bis 22,
**dadurch gekennzeichnet,**
**dass** die Trennlinie (21) aus leitenden Körpern (20) im Wesentlichen gerade ist und sich zwischen zwei gegenüber liegenden Kanten der Trägerschicht (10) erstreckt.

24. Serienverschaltung nach einem oder mehreren der Ansprüche 15 bis 23,
**dadurch gekennzeichnet,**
**dass** die Breite einer Trennlinie (21) in der Größenordnung von 10µm-3mm, insbesondere zwischen 10µm-500µm, liegt.

25. Serienverschaltung nach einem oder mehreren der Ansprüche 15 bis 24,
**dadurch gekennzeichnet,**
**dass** der Abstand zwischen zwei Trennlinien (21) in der Größenordnung von 1mm-3cm, insbesondere zwischen 3mm-5mm, liegt.

26. Serienverschaltung nach einem oder mehreren der Ansprüche 15 bis 25,
**dadurch gekennzeichnet,**
**dass** die Vorderkontaktschicht (40) aus einem leitenden Material besteht.

27. Serienverschaltung nach Anspruch 26,
**dadurch gekennzeichnet,**
**dass** die Vorderkontaktschicht (40) aus einem TCO (Transparent Conductive Oxide) besteht.

28. Serienverschaltung nach einem oder mehreren der Ansprüche 15 bis 27,
**dadurch gekennzeichnet,**
**dass** die Rückkontaktschicht (50) aus einem Metall, einem TCO (Transparent Conductive Oxide) oder einem leitfähigen Polymer besteht.

29. Serienverschaltung nach Anspruch 28,
**dadurch gekennzeichnet,**
**dass** die Rückkontaktschicht (50) aus einem Polymer aus der Gruppe der Epoxidharze, Polyurethane, und/oder Polyimide mit leitfähigen Partikeln einer Gruppe aus Kohlenstoff, Indium, Nickel, Silber, Molybdän, Eisen, Nickelchrom, Aluminium und/oder entsprechenden Legierungen bzw. Oxiden besteht.

30. Serienverschaltung nach Anspruch 29,
**dadurch gekennzeichnet,**
**dass** die Rückkontaktschicht (50) aus einem intrinsischen leitfähigen Polymer besteht.

31. Serienverschaltung nach einem oder mehreren der Ansprüche 15 bis 30,
**dadurch gekennzeichnet,**
**dass** die Trennschnitte (60;61) mit einem isolierenden Material aufgefüllt sind.

32. Serienverschaltung nach einem oder mehreren der Ansprüche 15 bis 31,
**dadurch gekennzeichnet,**
**dass** die Breite der Serienverschaltung in der Größenordnung von 5-30 cm, insbesondere bei etwa 10cm, liegt.

33. Serienverschaltung nach einem oder mehreren der Ansprüche 15 bis 32,
**dadurch gekennzeichnet,**
**dass** die Serienverschaltung so mit einer anderen Serienverschaltung verbunden ist, dass die Rückkontaktschicht (50) in Kontakt mit einer Vorderkontaktschicht der anderen Serienverschaltung steht.

34. Serienverschaltung nach Anspruch 33,
**dadurch gekennzeichnet,**
**dass** die Serienverschaltung schindelartig mit wenigstens einer anderen Serienverschaltung verbunden ist, wobei die Rückkontaktschicht (50) auf einer Vorderkontaktschicht oder die Vorderkontaktschicht (40) auf einer Rückkontaktschicht der anderen Serienverschaltung liegt.

35. Serienverschaltung nach einem oder beiden der Ansprüche 33 und 34,
**dadurch gekennzeichnet,**
**dass** die Rückkontaktschicht (50) mit einem leitfähigen Kleber mit einer Vorderkontaktschicht der anderen Serienverschaltung verbunden ist.

36. Photovoltaikmodul,
**dadurch gekennzeichnet,**
**dass** es eine Serienverschaltung nach einem oder mehreren der Ansprüche 15 bis 35 umfasst.

## Claims

1. A method for the production of a series connection of solar cells with integrated semiconductor elements,
**characterized**
**by** the following features:
• incorporation of one or more conductive elements (20) into an insulating support layer (10) according to a pattern, whereby the conductive elements (20) protrude from the surface of the support layer on at least one side thereof, and the pattern provides at least one separation line (21) of a certain width, said line being formed by one or more conductive elements (20);
• incorporation of several spherical or granular semiconductor elements (30) into the insulating support layer (10) according to a pattern, whereby the semiconductor elements (30) consist of substrate cores that are coated with at least one conductive back contact layer made of molybdenum and of a superimposed semiconductor layer made of a I-III-VI compound semiconductor, and the semiconductor elements (30) protrude from the surface of the support layer on at least one side thereof, and the pattern provides that the areas next to or between several separation lines (21) consisting of conductive elements (20) are populated with semiconductor elements (30);
• removal of parts of the semiconductor elements (30) on one side of the support layer (10) until the back contact layer of the semiconductor element (30) is exposed;
• application of a conductive back contact layer (50) onto the side of the support layer (10) from which parts of the semiconductor elements (30) have been removed;
• application of a conductive front contact layer (40) onto the side of the support layer (10) from which no semiconductor elements have been removed, whereby, prior to the deposition of the front contact layer (40) and/or of the back contact layer (50), a buffer layer consisting of CdS and/or a layer consisting of intrinsic zinc oxide is deposited, or else a buffer layer consisting of CdS and/or a layer of intrinsic zinc oxide had already been deposited onto the employed granular or spherical semiconductor elements (30), and whereby the areas next to or between two separation lines (21) each form a solar cell;
• making of two separation cuts (60; 61) in each case along a separation line (21) consisting of conductive elements (20), whereby a first separation cut (60) is made into the front contact layer (40) and a second separation cut (61) is made into the back contact layer, the separation cuts being located on different sides of the appertaining separation line (21), and the separation cuts (60; 61) penetrating the back contact layer (50) all the way to the support layer (10).

2. The method according to Claim 1,
**characterized in that**
the spherical or granular semiconductor elements (30) have a layer consisting of a TCO (transparent conductive oxide).

3. The method according to one or both of the preceding Claims 1 and 2,
**characterized in that,**
aside from the removal of parts of the semiconductor elements (30), parts of the conductive elements (20) are also removed.

4. The method according to one or more of the preceding claims,
**characterized in that,**
aside from the removal of parts of the semiconductor elements (30), a part of the support layer (10) is also removed.

5. The method according to one or more of the preceding claims,
**characterized in that**
the conductive elements (20) and/or the semiconductor elements (30) are applied onto the support layer (10) by means of sprinkling, dusting and/or printing, and subsequently incorporated into the support layer.

6. The method according to one or more of the preceding claims,
**characterized in that**
several conductive elements (20) in the form of spherical or granular particles, in the form of strips or in the form of a paste are incorporated into the support layer (10).

7. The method according to one or more of the preceding claims,
**characterized in that**
the support layer (10) is a matrix with recesses into which the elements (20; 30) are incorporated.

8. The method according to one or more of the preceding claims,
**characterized in that**
the elements (20; 30) are incorporated into the support layer (10) by means of a heating and/or pressing procedure.

9. The method according to one or more of the preceding claims,
**characterized in that**
a separation line (21) consisting of conductive elements (20) extends between two opposite edges of the support layer (10).

10. The method according to one or more of the preceding claims,
**characterized in that**
parts of the elements (20; 30) and/or of the support layer (10) are removed by grinding, polishing, etching, thermal energy application and/or photolithographic processes.

11. The method according to one or more of the preceding claims,
**characterized in that**
the back contact layer (50) and the front contact layer (40) are deposited by means of PVD methods, CVD methods or other methods harmonized with the type of layer in question.

12. The method according to one or more of the preceding claims,
**characterized in that**
the separation cuts (60; 61) are made by means of methods such as cutting, scratching, etching, thermal energy application or photolithographic processes.

13. The method according to one or more of the preceding claims,
**characterized in that**
the width of a separation line (21) is in the order of magnitude of 10 µm to 3 mm, especially between 10 µm and 500 µm.

14. The method according to one or more of the preceding claims,
**characterized in that**
the distance between two separation lines (21) is in the order of magnitude of 1 mm to 3 cm, especially between 3 mm and 5 mm.

15. A series connection of solar cells with integrated semiconductor elements,
**characterized in that**
the series connection has at least the following features:
• an insulating support layer (10) into which one or more conductive elements (20) are incorporated according to a pattern, whereby the conductive elements (20) protrude from the surface of the support layer on at least one side thereof, and the pattern provides at least one separation line (21) of a certain width, said line being formed by one or more conductive elements (20);
• several spherical or granular semiconductor elements (30) in the insulating support layer (10), whereby the semiconductor elements (30) consist of a substrate core that is coated with at least one conductive back contact layer made of molybdenum and of a semiconductor layer made of a I-III-VI compound semiconductor, and the semiconductor elements (30) protrude from the surface of the support layer on at least one side thereof and they form a pattern in which the areas next to or between several separation lines (21) are populated with semiconductor elements (30);
• a conductive front contact layer (40) on one side of the support layer (10) on which the elements (20; 30) protrude from the layer;
• a conductive back contact layer (50) on the side of the support layer (10) that is opposite from the front contact layer (40);
• a buffer layer consisting of CdS and/or a layer consisting of intrinsic zinc oxide on the employed granular or spherical semiconductor elements (30);
• areas next to or between two separation lines (21) each form a solar cell;
• two separation cuts (60; 61) in each case along a row of conductive elements (20), whereby a first separation cut (60) is made into the front contact layer (40) and a second separation cut (61) is made into the back contact layer, the separation cuts being located on different sides of the appertaining row of conductive elements (20), and the separation cuts (60; 61) penetrating the back contact layer (50) all the way to the support layer (10); and
• on the side of the support layer (10) on which the back contact layer (50) of the solar cell is arranged, at least one of the semiconductor elements (30) has a surface by means of which a direct contact is established between the back contact layer (50) of the solar cell and the back contact layer of the semiconductor element (30).

16. The series connection according to Claim 15,
**characterized in that**
the support layer (10) is made of a thermoplastic material.

17. The series connection according to one or both of Claims 15 and 16,
**characterized in that**
the support layer (10) is made of a polymer from the group consisting of epoxides, polyurethanes, polyacrylics, polycarbonates, polyesters and/or polyimides.

18. The series connection according to one or more of Claims 15 to 17,
**characterized in that**
a conductive element (20) is formed by a paste or a strip.

19. The series connection according to one or more of Claims 15 to 18,
**characterized in that**
a conductive element (20) is formed by a spherical or granular particle.

20. The series connection according to Claim 19,
**characterized in that**
a conductive element (20) is made of a conductive material in solid form, or else a conductive element (20) consists of a substrate core that is coated with a conductive material.

21. The series connection according to Claim 20,
**characterized in that**
a conductive element (20) is made of copper in solid form, or else of a substrate core that is coated with copper.

22. The series connection according to one or more of Claims 15 to 21,
**characterized in that**
the semiconductor elements (30) have a layer made of a TCO (transparent conductive oxide).

23. The series connection according to one or more of Claims 15 to 22,
**characterized in that** the separation line (21) made of conductive elements (20) is essentially straight and extends between two opposite edges of the support layer (10).

24. The series connection according to one or more of Claims 15 to 23, **characterized in that**
the width of a separation line (21) is in the order of magnitude of 10 µm to 3 mm, especially between 1 µm and 500 µm.

25. The series connection according to one or more of Claims 15 to 24,
**characterized in that**
the distance between two separation lines (21) is in the order of magnitude of 1 mm to 3 cm, especially between 3 mm and 5 mm.

26. The series connection according to one or more of Claims 15 to 25,
**characterized in that**
the front contact layer (40) is made of a conductive material.

27. The series connection according to Claim 26,
**characterized in that**
the front contact layer element (40) is made of a TCO (transparent conductive oxide).

28. The series connection according to one or more of Claims 15 to 27, **characterized in that**
the back contact layer element (50) is made of a metal, a TCO (transparent conductive oxide) or a conductive polymer.

29. The series connection according to Claim 28, **characterized in that**
the back contact layer (50) is made of a polymer from the group of epoxide resins, polyurethanes, and/or polyimides, with conductive particles from a group consisting of carbon, indium, nickel, silver, molybdenum, iron, nickel chrome, aluminum and/or the corresponding alloys or oxides.

30. The series connection according to Claim 29,
**characterized in that**
the back contact layer (50) is made of an intrinsic conductive polymer,

31. The series connection according to one or more of Claims 15 to 30, **characterized in that**
the separation cuts (60; 61) are filled up with an insulating material.

32. The series connection according to one or more of Claims 15 to 31, **characterized in that**
the width of the series connection is in the order of magnitude of 5 cm to 30 cm, especially about 10 cm.

33. The series connection according to one or more of Claims 15 to 32, **characterized in that**
the series connection is connected to another series connection in such a way that the back contact layer (50) is in contact with a front contact layer of the other series connection.

34. The series connection according to Claim 33, **characterized in that**
the series connection is connected in a shingle-like arrangement to another series connection, whereby the back contact layer (50) lies on a front contact layer or the front contact layer (40) lies on a back contact layer of the other series connection.

35. The series connection according to one or both of Claims 33 and 34, **characterized in that**
the back contact layer (50) is connected by means of a conductive adhesive to a front contact layer of the other series connection.

36. A photovoltaic module, **characterized in that**
it comprises a series connection according to one or more of Claims 15 to 35.

## Revendications

1. Procédé pour réaliser une connexion en série de cellules solaires avec des corps semi-conducteurs intégrés, **caractérisé par** les caractéristiques suivantes:
- introduction d'un ou de plusieurs corps conducteurs (20) dans une couche de support isolante (10) selon un motif, les corps conducteurs (20) faisant saillie au moins sur un côté de la couche de support hors de la surface de la couche de support et le motif prévoyant au moins une ligne de séparation (21) d'une largeur déterminée qui est constituée d'un ou de plusieurs corps conducteurs (20);
- introduction de plusieurs corps semi-conducteurs sphériques ou en forme de grains (30) dans la couche de support isolante (10) selon un motif, les corps semi-conducteurs (30) étant composés de noyaux de substrat qui sont revêtus au moins d'une couche de contact arrière conductrice en molybdène et d'une couche semi-conductrice située au-dessus de cette couche et composée d'un semi-conducteur composé I-III-VI, et les corps semi-conducteurs (30) faisant saillie au moins sur un côté de la couche de support hors de la surface de la couche de support et le motif prévoyant que les zones situées à côté d'une ou entre plusieurs lignes de séparation (21) constituées de corps conducteurs (20) sont équipées de corps semi-conducteurs (30);
- enlèvement de parties des corps semi-conducteurs (30) sur un côté de la couche de support (10) jusqu'à ce que la couche de contact arrière des corps semi-conducteurs (30) soit dégagée;
- application d'une couche de contact arrière conductrice (50) sur le côté de la couche de support (10) sur lequel ont été enlevées des parties des corps semi-conducteurs (30);
- application d'une couche de contact avant conductrice (40) sur le côté de la couche de support (10) sur lequel des corps semi-conducteurs n'ont pas été enlevés, une couche tampon en CdS et/ou une couche en oxyde de zinc intrinsèque étant déposées ou une couche tampon en CdS et/ou une couche en oxyde de zinc intrinsèque ayant déjà été déposées sur les corps semi-conducteurs (30) en forme de grains ou sphériques utilisés, et ce avant le dépôt de la couche de contact avant (40) et/ou de la couche de contact arrière (50), et les zones situées à côté d'une ou entre deux lignes de séparation (21) constituant respectivement une cellule solaire;
- application de respectivement deux coupes de séparation (60; 61) le long d'une ligne de séparation (21) constituée de corps conducteurs (20), une première coupe de séparation (60) étant appliquée dans la couche de contact avant (40) et une deuxième coupe de séparation (61), dans la couche de contact arrière, les coupes de séparation étant situées sur des côtés différents de la ligne de séparation respective (21) et les coupes de séparation (60; 61) pénétrant dans la couche de contact arrière (50) jusqu'à la couche de support (10).

2. Procédé selon la revendication 1, **caractérisé en ce que** les corps semi-conducteurs sphériques ou en forme de grains (30) présentent une couche d'un oxyde conducteur transparent (TCO, Transparent Conductive Oxide).

3. Procédé selon l'une des ou les deux revendications précédentes 1 et 2, **caractérisé en ce que**, outre l'enlèvement de parties des corps semi-conducteurs (30), des parties des corps conducteurs (20) sont enlevées.

4. Procédé selon l'une ou plusieurs des revendications précédentes, **caractérisé en ce que**, outre l'enlèvement de parties des corps semi-conducteurs (30), une partie de la couche de support (10) est enlevée.

5. Procédé selon l'une ou plusieurs des revendications précédentes, **caractérisé en ce que** les corps conducteurs (20) et/ou les corps semi-conducteurs (30) sont appliqués par épandage, saupoudrage et/ou impression sur la couche de support (10) et ensuite introduits dans la couche de support.

6. Procédé selon l'une ou plusieurs des revendications précédentes, **caractérisé en ce que** plusieurs corps conducteurs (20) sont introduits dans la couche de support (10) sous la forme de particules sphériques ou en forme de grains, sous la forme de bandes ou sous la forme d'une pâte.

7. Procédé selon l'une ou plusieurs des revendications précédentes, **caractérisé en ce que** la couche de support (10) est une matrice avec des creux dans lesquels sont introduits les corps (20; 30).

8. Procédé selon l'une ou plusieurs des revendications précédentes, **caractérisé en ce que** les corps (20; 30) sont introduits dans la couche de support (10) par une opération de réchauffement et/ou de pression.

9. Procédé selon l'une ou plusieurs des revendications précédentes, **caractérisé en ce qu'**une ligne de séparation (21) constituée de corps conducteurs (20) s'étend entre deux bords opposés de la couche de support (10).

10. Procédé selon l'une ou plusieurs des revendications précédentes, **caractérisé en ce que** l'enlèvement des parties des corps (20; 30) et/ou de la couche de support (10) s'effectue par meulage, polissage, gravure, apport d'énergie thermique et/ou des processus photolithographiques.

11. Procédé selon l'une ou plusieurs des revendications précédentes, **caractérisé en ce que** la couche de contact arrière (50) et la couche de contact avant (40) sont déposées par des procédés PVD, des procédés CVD ou d'autres procédés adaptés au type de la couche respective.

12. Procédé selon l'une ou plusieurs des revendications précédentes, **caractérisé en ce que** les coupes de séparation (50; 61) sont appliquées par des procédés tels que le coupage, l'entaillage, la gravure, l'apport d'énergie thermique et/ou des processus photolithographiques.

13. Procédé selon l'une ou plusieurs des revendications précédentes, **caractérisé en ce que** la largeur d'une ligne de séparation (21) est de l'ordre de grandeur de 10 µm à 3 mm, et est en particulier comprise entre 10 µm et 500 µm.

14. Procédé selon l'une ou plusieurs des revendications précédentes, **caractérisé en ce que** la distance entre deux lignes de séparation (21) est de l'ordre de grandeur de 1 mm à 3 cm, et est en particulier comprise entre 3 mm et 5 mm.

15. Connexion en série de cellules solaires avec des corps semi-conducteurs intégrés, **caractérisée en ce que** la connexion en série présente au moins les caractéristiques suivantes:
- une couche de support isolante (10) dans laquelle un ou plusieurs corps conducteurs (20) sont introduits selon un motif, les corps conducteurs (20) faisant saillie au moins sur un côté de la couche de support hors de la surface de la couche de support et le motif prévoyant au moins une ligne de séparation (21) d'une largeur déterminée qui est constituée d'un ou de plusieurs corps conducteurs (20);
- plusieurs corps semi-conducteurs sphériques ou en forme de grains (30) dans la couche de support isolante (10), les corps semi-conducteurs (30) étant composés d'un noyau de substrat qui est revêtu au moins d'une couche de contact arrière conductrice en molybdène et d'une couche semi-conductrice composée d'un semi-conducteur composé I-III-VI, et les corps semi-conducteurs (30) faisant saillie au moins sur un côté de la couche de support hors de la surface de la couche de support et constituant un motif dans lequel les zones situées à côté d'une ou entre plusieurs lignes de séparation (21) sont équipées de corps semi-conducteurs (30);
- une couche de contact avant conductrice (40) sur un côté de la couche de support (10) sur lequel les corps (20; 30) font saillie hors de la couche;
- une couche de contact arrière conductrice (50) sur le côté de la couche de support qui est opposé à la couche de contact avant (40);
- une couche tampon en CdS et/ou une couche in oxyde de zinc intrinsèque sur les corps semi-conducteurs (30) en forme de grains ou sphériques utilisés;
- des zones situées à côté d'une ou entre deux lignes de séparation (21) constituent respectivement une cellules solaire;
- respectivement deux coupes de séparation (60; 61) le long d'une ligne de corps conducteurs (20), une première coupe de séparation (60) étant appliquée dans la couche de contact avant (40) et une deuxième coupe de séparation (61), dans la couche de contact arrière, les coupes de séparation étant situées sur des côtés différents de la ligne respective de corps conducteurs (20) et les coupes de séparation (60; 61) pénétrant dans la couche de contact arrière (50) jusqu'à la couche de support (10) et
- au moins l'un des corps semi-conducteurs (30) présente, sur le côté de la couche de support (10) sur lequel est située la couche de contact arrière (50) de la cellule solaire, une surface par l'intermédiaire de laquelle il y a un contact direct entre la couche de contact arrière (50) de la cellule solaire et la couche de contact arrière du corps semi-conducteur (30).

16. Connexion en série selon la revendication 15, **caractérisée en ce que** la couche de support (10) se compose d'un matériau thermoplastique.

17. Connexion en série selon l'une des ou les deux revendications 15 et 16, **caractérisée en ce que** la couche de support (10) se compose d'un polymère du groupe des époxydes, polyuréthanes, polyacrylates, polycarbonates, polyesters et/ou polyimides.

18. Connexion en série selon l'une ou plusieurs des revendications 15 à 17, **caractérisée en ce qu'**un corps conducteur (20) est constitué par une pâte ou par une bande.

19. Connexion en série selon l'une ou plusieurs des revendications 15 à 18, **caractérisée en ce qu'**un corps conducteur (20) est constitué par une particule sphérique ou en forme de grain.

20. Connexion en série selon la revendication 19, **caractérisée en ce qu'**un corps conducteur (20) en matériau plein se compose d'un matériau conducteur ou un corps conducteur (20) se compose d'un noyau de substrat qui est revêtu d'un matériau conducteur.

21. Connexion en série selon la revendication 20, **caractérisée en ce qu'**un corps conducteur (20) en matériau plein se compose de cuivre ou d'un noyau de substrat qui est revêtu de cuivre.

22. Connexion en série selon l'une ou plusieurs des revendications 15 à 21,
**caractérisée en ce que** les corps semi-conducteurs (30) comportent une couche d'un oxyde conducteur transparent (TCO, Transparent Conductive Oxide).

23. Connexion en série selon l'une ou plusieurs des revendications 15 à 22, **caractérisée en ce que** la ligne de séparation (21) constituée de corps conducteurs (20) est sensiblement droite et s'étend entre deux bords opposés de la couche de support (10).

24. Connexion en série selon l'une ou plusieurs des revendications 15 à 23, **caractérisée en ce que** la largeur d'une ligne de séparation (21) est de l'ordre de grandeur de 10 µm à 3 mm et est en particulier comprise entre 10 µm et 500 µm.

25. Connexion en série selon l'une ou plusieurs des revendications 15 à 24, **caractérisée en ce que** la distance entre deux lignes de séparation (21) est de l'ordre de grandeur de 1 mm à 3 cm et est en particulier comprise entre 3 mm et 5 mm.

26. Connexion en série selon l'une ou plusieurs des revendications 15 à 25, **caractérisée en ce que** la couche de contact avant (40) se compose d'un matériau conducteur.

27. Connexion en série selon la revendication 26, **caractérisée en ce que** la couche de contact avant (40) se compose d'un oxyde conducteur transparent (TCO, Transparent Conductive Oxyde).

28. Connexion en série selon l'une ou plusieurs des revendications 15 à 27, **caractérisée en ce que** la couche de contact arrière (50) se compose d'un métal, d'un oxyde conducteur transparent (TCO, Transparent Conductive Oxyde) ou d'un polymère conducteur.

29. Connexion en série selon la revendication 28, **caractérisée en ce que** la couche de contact arrière (50) se compose d'un polymère du groupe des résines époxy, des polyuréthanes et/ou des polyimides avec des particules conductrices d'un groupe composé du carbone, de l'indium, du nickel, de l'argent, du molybdène, du fer, du nickel-chrome, de l'aluminium et/ou d'alliages ou d'oxydes correspondants.

30. Connexion en série selon la revendication 29, **caractérisée en ce que** la couche de contact arrière (50) se compose d'un polymère conducteur intrinsèque.

31. Connexion en série selon l'une ou plusieurs des revendications 15 à 30, **caractérisée en ce que** les coupes de séparation (60; 61) sont remplies d'un matériau isolant.

32. Connexion en série selon l'une ou plusieurs des revendications 15 à 31, **caractérisée en ce que** la largeur de la connexion en série est de l'ordre de grandeur de 5 à 30 cm, et est en particulier d'environ 10 cm.

33. Connexion en série selon l'une ou plusieurs des revendications 15 à 32, **caractérisée en ce que** la connexion en série est reliée à une autre connexion en série de manière telle que la couche de contact arrière (50) est en contact avec une couche de contact avant de l'autre connexion en série.

34. Connexion en série selon la revendication 33, **caractérisée en ce que** la connexion en série est reliée à au moins une autre connexion en série à chevauchement de type bardeaux, la couche de contact arrière (50) étant sur une couche de contact avant ou la couche de contact avant (40), sur une couche de contact arrière de l'autre connexion en série.

35. Connexion en série selon l'une des ou les deux revendications 33 et 34, **caractérisée en ce que** la couche de contact arrière (50) est reliée à une couche de contact avant de l'autre connexion en série par une colle conductrice.

36. Module photovoltaïque, **caractérisé en ce qu'**il comprend une connexion en série selon l'une ou plusieurs des revendications 15 à 35,
